# FASCICULE DE BREVET EUROPEEN

(11) **EP 0 619 616 B1**
(45) Date de publication et mention de la délivrance du brevet: **06.11.1996**
(21) Numéro de dépôt: 94400748.3
(22) Date de dépôt: 06.04.1994
(51) Int. Cl.: H01L 35/08, G01N 25/68

(54) **Dispositif à effet peltier, notamment pour la détection d'un risque de condensation sur une surface se trouvant au contact d'un volume d'air humide**
Peltiereffektapparat zur Detektion der Wahrscheinlichkeit von Kondensationsbildung an einer Oberfläche, die sich in Kontakt mit feuchter Luft befindet
Apparatus exploiting the Peltier effect to detect the risk of condensation on a surface which borders a volume of humid air

(30) Priorité: 06.04.1993 FR 9304058
(43) Date de publication de la demande: 12.10.1994
(73) Titulaire: IMRA EUROPE S.A., F-06560 Valbonne (FR)
(72) Inventeur: Gschwind, Michel, F-06130 Grasse (FR); Ancey, Pascal, F-06650 Le Rouret (FR)
(74) Mandataire: Leszczynski, André

(56) Documents cités:
- US-A- 4 343 960
- US-A- 4 677 416
- US-A- 4 859 250
- PATENT ABSTRACTS OF JAPAN vol. 10, no. 312 (P-509)23 Octobre 1986 & JP-A-61 124 857

## Description

La présente invention concerne un dispositif à effet PELTIER, notamment pour la détection d'un risque de condensation sur une surface se trouvant au contact d'un volume d'air humide.

On connaît déjà des dispositifs de détermination du point de rosée et de l'humidité de l'air ambiant.

Le document US-A-4 677 416 décrit un dispositif comprenant un substrat sur la face supérieure duquel sont principalement formées des bandes semi-conductrices en PbTe de type alternativement N et P s'étendant entre une zone périphérique et une zone centrale de ladite face supérieure du substrat, raccordées en série par des jonctions de types N-P et P-N pour constituer un circuit formé alternativement de bandes de type N et de bandes de type P, toutes les jonctions de type N-P étant situées dans la zone centrale du substrat, alors que toutes les jonctions de type P-N sont situées dans la zone périphérique dudit substrat.

Dans un tel dispositif, lors du passage d'un courant dans le circuit série, la zone centrale du substrat est refroidie par effet PELTIER, une quantité de chaleur étant absorbée par les jonctions présentes dans la zone centrale et dégagée, aux effets Joule près, par les jonctions présentes dans la zone périphérique du substrat.

Mais l'efficacité de ce dispositif peut s'avérer insuffisante du fait que, les jonctions périphériques se situant sur la même face du substrat que la zone de détection, celle-ci peut, lors de son refroidissement par effet PELTIER, recevoir une partie de l'énergie thermique dégagée par lesdites jonctions périphériques.

Cette énergie thermique est d'ailleurs en grande partie d'abord transmise par conduction dans l'épaisseur du substrat avant d'être dissipée.

On peut s'accommoder de ces inconvénients dans le cas d'une mesure de point de rosée.

En revanche, lorsque l'on désire détecter un risque de condensation par exemple en mettant en oeuvre le procédé décrit dans la demande de brevet non publiée n° 93 02099 de la demanderesse, il est préférable de disposer d'un dispositif à effet PELTIER qui soit apte à dissiper rapidement l'énergie thermique dégagée par les jonctions situées en dehors de la zone de détection, sans que cette dernière ne subisse l'influence de cette dissipation.

La présente invention vise à fournir un dispositif à effet PELTIER, adapté notamment à la mise en oeuvre d'un procédé de détection du risque de condensation sur une surface se trouvant au contact d'un volume d'air humide, qui présente le double avantage d'une part de dissiper rapidement l'énergie thermique dégagée par les jonctions situées en dehors de la zone de détection et d'autre part de découpler thermiquement cette zone de détection des jonctions situées en dehors de la zone de détection.

En outre, le dispositif selon l'invention comporte une zone de détection présentant une masse thermique avantageusement faible par rapport à celle de la zone du substrat dans laquelle s'effectue la dissipation de l'énergie dégagée par les jonctions situées en dehors de la zone de détection.

Ainsi, l'inertie thermique de la zone de détection est suffisamment faible pour permettre à cette dernière de réagir rapidement et avec un rendement thermique optimal à tout chauffage ou refroidissement exercé par les jonctions centrales du substrat lorsqu'elles sont traversées par un courant électrique, et ce pour une consommation réduite d'énergie électrique.

Le dispositif selon l'invention est en outre d'un mode de réalisation particulièrement simple et économique.

La présente invention a pour objet un dispositif à effet PELTIER, notamment pour la détection d'un risque de condensation sur une surface se trouvant au contact d'un volume d'air humide, comportant un substrat sur lequel sont formées des bandes semi-conductrices de type N et P s'étendant entre une zone périphérique et une zone centrale de la face supérieure du substrat, des jonctions raccordant lesdites bandes semi-conductrices pour former un circuit série constitué alternativement par des bandes de type N et des bandes de type P, toutes les jonctions d'un même type, par exemple N-P, étant situées dans la zone centrale de la face supérieure du substrat et formant une zone de détection du dispositif, caractérisé par le fait que les bandes semi-conductrices de type N sont disposées d'un côté de la face supérieure du substrat tandis que les bandes semi-conductrices de type P sont disposées de l'autre côté de la face supérieure du substrat, le substrat comportant, au droit de l'extrémité de chaque bande située dans la zone périphérique, un trou métallisé traversant le substrat et débouchant sur la face inférieure de ce dernier, et une métallisation de sa face inférieure formant des bandes de jonction raccordant chacune un trou traversant situé au droit de l'extrémité d'une bande de type P à un autre trou traversant situé au droit de l'extrémité d'une bande de type N voisine.

On comprend que les métallisations qui traversent le substrat de part en part et s'étendent sur sa face inférieure sensiblement parallèlement aux bandes semi-conductrices situées sur sa face supérieure constituent des jonctions d'un même type (par exemple P-N) qui, associées aux jonctions (par exemple de type N-P) présentes dans la zone de détection du substrat formant un élément PELTIER permettant de réaliser des échanges thermiques entre la zone centrale du substrat et l'extérieur dudit substrat.

De préférence, les jonctions présentes dans la zone centrale de la face supérieure du substrat sont recouvertes d'un matériau isolant électriquement et thermiquement conducteur qui les réunit pour constituer la zone de détection du dispositif selon l'invention.

Comme il a été expliqué plus haut, la masse thermique de ce matériau est avantageusement faible pour assurer une bonne réactivité de la zone de détection aux sollicitations thermiques des jonctions centrales.

Selon un mode de réalisation préféré de l'invention, les bandes semi-conductrices sont réalisées par diffusion thermique d'impuretés dans du silicium. On peut à cet effet utiliser comme impuretés de l'arsenic et du bore.

On réalise de préférence un fort dopage (de l'ordre de 10¹⁹ porteurs par cm³), ce qui présente les deux avantages suivants.

D'une part, la conductivité des bandes semi-conductrices étant beaucoup plus élevée que celle du silicium (qui ne comporte que de l'ordre de 10¹⁰ porteurs par cm³), il n'existe pratiquement aucun risque de fuite électrique dans le substrat.

D'autre part, le contact entre les bandes de type N et les bandes de type P est de bonne qualité et il n'est pas nécessaire d'enrichir les dopages au niveau de la jonction pour obtenir un contact de type ohmique.

Pour isoler thermiquement les jonctions présentes sur la face supérieure du substrat de celles présentes sur sa face inférieure, on peut, selon une première variante, placer une épaisseur d'un matériau électriquement et thermiquement isolant, par exemple un oxyde de silicium SiO₂, dans la partie centrale du substrat, cette partie centrale s'étendant de préférence au maximum jusqu'aux trous traversant le substrat.

Il est en effet préférable que lesdits trous traversants soient réalisés dans la zone thermiquement conductrice du substrat, de manière à favoriser le transfert et la dissipation de l'énergie thermique dégagée dans les métallisations présentes dans les trous traversants, bien que cette énergie thermique ne soit pas prépondérante par rapport à celle dégagée par les jonctions situées sur la face inférieure du substrat.

Selon une seconde variante, on peut évider sur une épaisseur déterminée la partie centrale de la face supérieure du substrat, pour laisser les bandes semi-conductrices séparées du fond de l'évidement par une couche d'air qui joue ainsi le rôle d'isolant thermique.

Il en résulte un meilleur rendement du dispositif et un découplage optimal entre la zone de détection et les jonctions situées en dehors de cette zone de détection.

Il est clair que, grâce à l'étendue surfacique des jonctions situées sur la face inférieure du substrat, l'énergie thermique dégagée par ces dernières peut être directement transmise par conduction à un radiateur sur lequel est placé le substrat, ce radiateur assurant la dissipation de cette énergie par convexion.

Pour déterminer un risque de condensation sur une surface, on place le dispositif selon l'invention avec sa face inférieure contre ladite surface qui joue ainsi le rôle de radiateur en réalisant des échanges thermiques avec les jonctions situées sur la face inférieure du substrat.

De plus, du fait de la compacité du dispositif selon l'invention, en l'absence de courant électrique circulant dans le circuit PELTIER, la totalité du substrat prend une température homogène qui est celle de la surface sur laquelle on détecte un risque de condensation.

De cette manière, on peut mettre en oeuvre le procédé de détection sachant que la température initiale de la zone de détection est sensiblement celle de ladite surface.

Par ailleurs, du fait que toutes les bandes semi-conductrices de type N sont disposées d'un côté du substrat tandis que toutes les bandes semi-conductrices de type P sont disposées de l'autre côté du substrat, la réalisation technique du dispositif selon l'invention est simple.

En effet, il suffit de diffuser thermiquement une impureté, par exemple de l'arsenic, pour former une couche de type N sensiblement rectangulaire d'un côté de la face supérieure du substrat puis, par photogravure, de dégager des bandes de type N. On procède de même pour les bandes de type P en diffusant par exemple du bore.

Dans un mode de réalisation préféré de l'invention, les jonctions présentes dans la zone centrale de la face supérieure du substrat sont également réalisées par une métallisation de surface, par recouvrement des extrémités voisines des bandes semi-conductrices de types N et P.

Avantageusement, le substrat comporte également d'autres circuits électroniques permettant la mise en oeuvre d'un procédé de détermination de risque de condensation, notamment celui décrit par la demanderesse dans sa demande de brevet non publiée n° 93 02099.

En particulier, le substrat peut intégrer un étage d'amplification permettant de fournir des signaux amplifiés de tension aux bornes du circuit série formé sur le substrat, de manière à analyser ces signaux pour conduire le procédé de détection.

Selon un mode de réalisation particulier de l'invention, l'une des jonctions de la zone de détection est réservée à la réalisation d'un thermocouple, les autres jonctions étant raccordées comme décrit ci-dessus pour former le circuit PELTIER.

Le thermocouple ainsi réalisé permet d'effectuer une mesure de la température de la zone de détection en cours d'exécution du procédé de détection.

Ce mode de réalisation est avantageux en ce que le thermocouple ne nécessite pas d'étape de fabrication spécifique mais est issu des mêmes opérations de diffusion thermique et de gravure que les autres jonctions. Seule est nécessaire une métallisation de surface supplémentaire reliant les bornes de ce thermocouple à celles du circuit électronique présent par exemple sur le substrat.

Dans un mode de réalisation préféré de l'invention, le substrat est recouvert d'une couche protectrice, thermiquement et électriquement isolante, par exemple en nitrure de silicium Si₃N₄.

Dans le but de mieux faire comprendre l'invention, on va en décrire maintenant un mode de réalisation donné à titre d'exemple non limitatif en référence au dessin annexé dans lequel
- la figure 1 est une vue de dessus d'un dispositif à effet PELTIER selon l'invention non recouvert d'une couche protectrice,
- les figures 1A, 1B et 1C sont respectivement des vues en coupe selon A-A, B-B et C-C de la figure 1,
- la figure 2 est une vue analogue à la figure 1, le dispositif étant recouvert d'une couche protectrice,
- la figure 2A est une vue en coupe selon A-A de la figure 2,
- la figure 3 représente en perspective la disposition des bandes semi-conductrices et des jonctions du dispositif décrit, et
- les figures 4, 4A, 4B et 4C sont des vues analogues aux figures 1, 1A, 1B et 1C d'un dispositif selon un autre mode de réalisation de l'invention.

Le dispositif selon l'invention se présente ici sous la forme d'une plaque rectangulaire 1 comprenant une face supérieure 1a et une face inférieure 1b.

La plaque 1 constitue un substrat réalisé en un matériau électriquement isolant et thermiquement conducteur tel que du silicium.

Dans sa partie centrale, la plaque 1 comporte un évidement rectangulaire 2 qui s'étend depuis sa face supérieure 1a jusqu'à sa face inférieure 1b, et qui est rempli d'un matériau thermiquement et électriquement isolant tel que de l'oxyde de silicium SiO₂.

Sur la face supérieure 1a du substrat, au-dessus du matériau thermiquement et électriquement isolant, on a formé des bandes semi-conductrices de type N 3 et de type P 4 par diffusion thermique d'arsenic et de bore.

Celles-ci s'étendent depuis l'axe médian 5 du substrat 1 jusqu'à la zone périphérique thermiquement conductrice de ce dernier.

Les bandes semi-conductrices de type N 3 et de type P 4 sont disposées symétriquement par rapport à l'axe médian 5, les bandes de type N 3 se trouvant toutes d'un même côté de l'axe 5, tandis que celles de type P 4 se trouvent toutes de l'autre côté de l'axe médian 5.

Les bandes semi-conductrices été formées par diffusion thermique d'ions sur une partie rectangulaire s'étendant sur le côté correspondant de la face supérieure 1a du substrat, chaque couche ayant été ensuite photogravée.

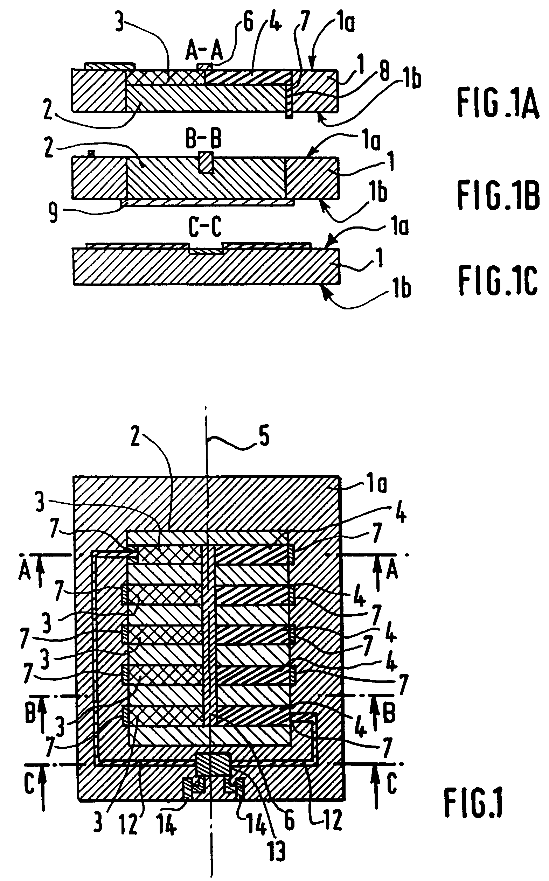

Sur la figure 1A, on a représenté une jonction verticale entre la bande de type N 3 et la bande de type P 4.

Dans la pratique, il peut s'avérer difficile de réaliser une telle jonction verticale. On préfère alors, selon une variante de l'invention, espacer les extrémités des bandes 3 et 4 et former une jonction par application d'une métallisation de surface recouvrant partiellement l'extrémité desdites bandes 3 et 4.

Par ailleurs, ces jonctions entre les bandes de type N 3 et les bandes de type P 4 sont recouvertes par une bande 6 d'un matériau électriquement isolant et thermiquement conducteur s'étendant selon l'axe médian 5.

Le matériau de la bande 6 peut être avantageusement le même que celui qui forme la zone périphérique du substrat 1. Il est préférable que la bande 6 présente une masse thermique faible comme il a déjà été expliqué.

La face supérieure de la bande 6 constitue la zone de détection qui subit des phases de chauffage et de refroidissement lors de la mise en oeuvre du procédé de détection de risque de condensation.

Au droit des extrémités des bandes 3 et 4 situées dans la zone périphérique du substrat 1, sont réalisés des trous traversant 7 reliant la face supérieure 1a du substrat à sa face inférieure 1b.

Les trous traversants 7 comportent une métallisation en volume 8 qui se trouve au contact électrique des bandes semi-conductrices 3 et 4.

Sur la face inférieure 1b du substrat, des bandes électriquement conductrices 9 sont réalisées par métallisation et photogravure de la surface inférieure 1b du substrat.

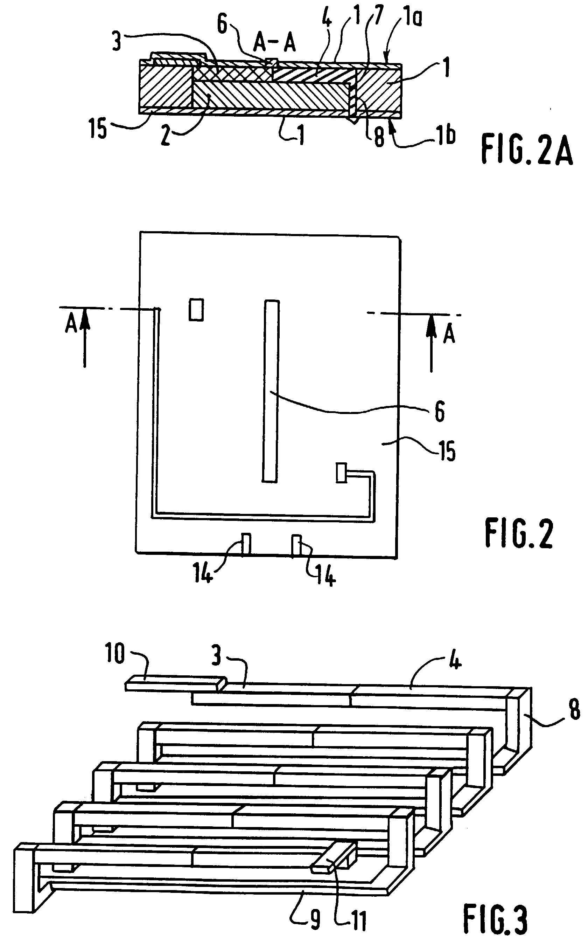

Les bandes 9 relient deux à deux les trous traversants 7 situés au droit des bandes semi-conductrices du type N 3 à ceux situés au droit des bandes semi-conductrices voisines de type P 4, comme on le voit plus clairement sur la figure 3.

On comprend que les métallisations en volume 8 et les métallisations de surface 9 constituent les jonctions qui, associées aux jonctions formées sur la face supérieure du substrat, constituent les parties chauffantes et refroidissantes d'un circuit série à effet PELTIER comprenant alternativement une bande de type N 3, une jonction N-P, une bande de type P 4, une jonction P-N etc...

Grâce à la présence du matériau thermiquement isolant dans l'évidement 2, les jonctions des faces supérieure et inférieures sont thermiquement découplées.

On voit clairement que les jonctions qui sont formées par les métallisations 9 s'étendant sur la face inférieure 1b du substrat peuvent efficacement transmettre leur énergie thermique à un radiateur contre lequel elles sont appliquées, ou à une surface sur laquelle on désire détecter un risque de condensation.

Les bornes 10 et 11 du circuit PELTIER sont raccordées, au moyen de métallisations 12, à un circuit intégré 13 également réalisé sur le substrat. Ce circuit 13 peut regrouper notamment un étage d'amplification permettant de fournir un signal amplifié de la tension présente aux bornes 10, 11 du circuit série à effet PELTIER. Des contacts d'alimentation 14 sont formés sur la face supérieure 1a du substrat et permettent le raccordement du dispositif à une source électrique.

Comme représenté sur les figures 2 et 2a, le dispositif ainsi réalisé peut comporter une couche protectrice 15, par exemple en nitrure de silicium Si₃N₄, qui recouvre sa face inférieure 1b et sa face supérieure 1a, à l'exception de la bande de détection 6 et des contacts d'alimentation 14 qui doivent être laissés à l'air libre pour le raccordement électrique du dispositif selon l'invention.

Dans une variante non illustrée, les bandes de type N 3 et de type P 4 pourraient être réparties radialement sur un substrat de forme circulaire, ce qui permettrait de réaliser une zone de détection 6 en forme de pastille située au centre dudit substrat et présentant par conséquent une surface très réduite, ce qui permettrait de diminuer encore sa masse thermique.

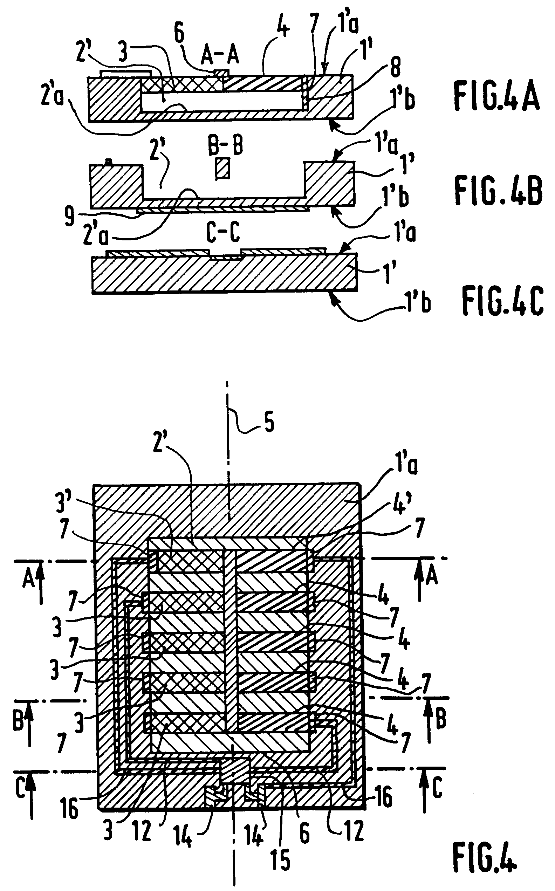

Sur les figures 4, 4A, 4B et 4C, on a représenté un mode de réalisation de l'invention dans lequel l'évidement central 2' ne s'étend pas sur toute l'épaisseur du substrat 1' mais comporte un fond 2'a.

L'évidement 2' a été creusé sur la face supérieure du substrat 1' après formation des bandes de type N 3 et P 4.

Une couche d'air sépare les bandes semi-conductrices 3 et 4 du substrat 1' et constitue un isolant thermique permettant de découpler la zone de détection des jonctions 8 et 9.

La figure 4 illustre également un mode de réalisation particulier, compatible avec celui décrit en référence aux figures 1 et 2, selon lequel l'une des jonctions centrales est utilisée en dehors du circuit PELTIER en tant que thermocouple.

A cet effet, les bandes 3' et 4', dont la jonction est également recouverte par la bande 6, sont directement raccordées au circuit intégré 13 par des métallisations 16.

On peut ainsi conduire un procédé de détection tel que celui décrit dans la demande de brevet n° 93 02099 de la demanderesse en contrôlant les valeurs exactes de température de la zone de détection du dispositif. Grâce au circuit intégré 13, on peut corriger les éventuelles dérives en température de cette zone de détection par rapport à la température initiale de la surface sur laquelle on détecte un risque de condensation.

## Revendications

1. Dispositif à effet PELTIER, notamment pour la détection d'un risque de condensation sur une surface se trouvant au contact d'un volume d'air humide, comportant un substrat sur lequel sont formées des bandes semi-conductrices s'étendant entre une zone périphérique et une zone centrale de la face supérieure du substrat, des jonctions raccordant lesdites bandes pour former un circuit série constitué alternativement par des bandes de type N et des bandes de type P, toutes les jonctions d'un même type étant situées dans la zone centrale de la face supérieure du substrat et formant une zone de détection du dispositif, caractérisé par le fait que les bandes semi-conductrices de type N (3) sont disposées d'un côté de la face supérieure (1a,1'a) du substrat (1,1') tandis que les bandes semi-conductrices de type P (4) sont disposées de l'autre côté de la face supérieure (1a,1'a) du substrat (1,1'), le substrat (1,1') comportant, au droit de l'extrémité de chaque bande (3, 4) située dans la zone périphérique, un trou (7) métallisé (8) traversant le substrat (1,1') et débouchant sur la face inférieure (1b,1'b) de ce dernier, et une métallisation de sa face inférieure (1b,1'b) formant des bandes de jonction (9) raccordant chacune un trou traversant (7) situé au droit de l'extrémité d'une bande de type P (4) à un autre trou traversant (7) situé au droit de l'extrémité d'une bande de type N (3) voisine.

2. Dispositif selon la revendication 1, caractérisé par le fait que les jonctions présentes dans la zone centrale de la face supérieure (1a,1'a) du substrat (1,1') sont recouvertes d'un matériau (6) électriquement isolant et thermiquement conducteur qui les réunit pour constituer la zone de détection du dispositif.

3. Dispositif selon l'une quelconque des revendications 1 et 2, caractérisé par le fait que le substrat (1,1') est constitué par du silicium et que les bandes semi-conductrices (3,4) sont réalisées en silicium dopé par diffusion thermique d'impuretés telles que l'arsenic et le bore.

4. Dispositif selon l'une quelconque des revendications 1 à 3, caractérisé par le fait que le substrat (1) comporte, dans sa partie centrale (2), un matériau électriquement et thermiquement isolant, tel qu'un oxyde de silicium.

5. Dispositif selon l'une quelconque des revendications 1 à 3, caractérisé par le fait que le substrat (1') comporte, dans sa partie centrale, un évidement (2') qui s'étend depuis la face supérieure (1'a) du substrat (1') jusqu'à une profondeur supérieure à celle des bandes semi-conductrices (3,4) formées sur le substrat (1'), lesdites bandes (3,4) se trouvant ainsi isolées du fond (2'a) de l'évidement (2') par une couche d'air.

6. Dispositif selon l'une quelconque des revendications 1 à 5, caractérisé par le fait que les jonctions présentes dans la zone centrale de la partie supérieure (1a,1'a) du substrat (1,1') sont constituées par des métallisations de surface recouvrant partiellement les extrémités des bandes semi-conductrices (3, 4).

7. Dispositif selon l'une quelconque des revendications 1 à 6, caractérisé par le fait qu'il comporte deux bandes semi-conductrices (3', 4') isolées électriquement du circuit série et formant un thermocouple.

## Patentansprüche

1. Peltiereffekt-Vorrichtung insbesondere zum Erfassen einer Kondensationsgefahr auf einer Oberfläche, die sich mit einem Volumen feuchter Luft in Kontakt befindet, umfassend ein Substrat, auf dem halbleitende Bänder gebildet sind, die sich zwischen einem Umfangsbereich und einem zentralen Bereich der Oberseite des Substrats erstrecken, wobei Verbindungen diese Bänder verbinden, um eine abwechselnd aus Bändern vom N-Typ und Bändern vom P-Typ bestehende Reihenschaltung zu bilden, wobei alle Übergänge vom gleichen Typ im zentralen Bereich der Oberseite des Substrats gelegen sind und einen Erfassungsbereich der Vorrichtung bilden, dadurch gekennzeichnet, daß die halbleitenden Bänder vom N-Typ (3) auf einer Seite der Oberseite (la, l'a) des Substrats (1, 1') angeordnet sind, während die halbleitenden Bänder vom P-Typ (4) auf der anderen Seite der Oberseite (1a, 1'a) des Substrats (1, 1') angeordnet sind, wobei das Substrat (1, 1') auf Höhe des im Umfangsbereich gelegenen Endes jedes Bandes (3, 4) ein das Substrat (1, 1') durchquerendes und auf dessen Unterseite (1b, 1'b) ausmündendes metallisiertes (8) Loch (7) und eine Metallisierung seiner Unterseite (1b, 1'b) aufweist, die Verbindungsbänder (9) bildet, die jeweils ein auf Höhe des Endes eines Bandes vom P-Typ (4) gelegenes durchquerendes Loch (7) mit einem anderen auf Höhe des Endes eines benachbarten Bandes vom N-Typ (3) gelegenen durchquerenden Loch (7) verbinden.

2. Vorrichtung nach Anspruch 1, dadurch gekennzeichnet, daß die im zentralen Bereich der Oberseite (1a, 1'a) des Substrats (1, 1') vorhandenen Verbindungen mit einem elektrisch isolierenden und thermisch leitenden Werkstoff (6) bedeckt sind, der sie verbindet, um den Erfassungsbereich der Vorrichtung zu bilden.

3. Vorrichtung nach einem der Ansprüche 1 und 2, dadurch gekennzeichnet, daß das Substrat (1, 1') aus Silicium besteht und daß die halbleitenden Bänder (3, 4) aus Silicium bestehen, das durch Wärmediffusion mit Verunreinigungen wie Arsen und Bor dotiert ist.

4. Vorrichtung nach einem der Ansprüche 1 bis 3, dadurch gekennzeichnet, daß das Substrat (1) in seinem zentralen Bereich (2) einen elektrisch und thermisch isolierenden Werkstoff wie ein Siliciumoxid aufweist.

5. Vorrichtung nach einem der Ansprüche 1 bis 3, dadurch gekennzeichnet, daß das Substrat (1') in seinem zentralen Bereich eine Aussparung (2') aufweist, die sich von der Oberseite (1'a) des Substrats (1') bis zu einer Tiefe erstreckt, die größer als die der auf dem Substrat (1') gebildeten halbleitenden Bänder (3, 4) ist, die auf diese Weise vom Boden (2'a) der Aussparung (2') durch eine Luftschicht getrennt sind.

6. Vorrichtung nach einem der Ansprüche 1 bis 5, dadurch gekennzeichnet, daß die im zentralen Bereich des oberen Teils (1a, 1'a) des Substrats (1, 1') vorhandenen Verbindungen aus Oberflächenmetallisierungen bestehen, die die Enden der halbleitenden Bänder (3, 4) teilweise bedecken.

7. Vorrichtung nach einem der Ansprüche 1 bis 6, dadurch gekennzeichnet, daß sie zwei halbleitende Bänder (3', 4') besitzt, die elektrisch von der Reihenschaltung getrennt sind und ein Thermopaar bilden.

## Claims

1. Peltier-effect device, especially for detecting the risk of condensation on a surface lying in contact with a volume of humid air, comprising a substrate on which semiconductor strips are formed, these strips extending between a peripheral region and a central region of the upper face of the substrate, junctions connecting the said strips in order to form a series circuit consisting alternately of n-type strips and p-type strips, all of the junctions of the same type being located in the central region of the upper face of the substrate and forming a detection region of the device, characterized in that the n-type semiconductor strips (3) are arranged on one side of the upper face (1a, 1'a) of the substrate (1, 1') while the p-type semiconductor strips (4) are arranged on the other side of the upper face (1a, 1'a) of the substrate (1, 1'), the substrate (1, 1') comprising, in line with the end of each strip (3, 4) located in the peripheral region, a plated-through hole (8) passing through the substrate (1, 1') and emerging on the lower face (1b, 1'b) of the latter and a metallization of its lower face (1b, 1'b) forming junction strips (9) each connecting a through-hole (7) located in line with the end of a p-type strip (4) to another through-hole (7) located in line with the end of an adjacent n-type strip (3).

2. Device according to Claim 1, characterized in that the junctions present in the central region of the upper face (1a, 1'a) of the substrate (1, 1') are covered with an electrically insulating and thermally conductive material (6) which joins them together in order to constitute the detection region of the device.

3. Device according to either of Claims 1 and 2, characterized in that the substrate (1, 1') consists of silicon and in that the semiconductor strips (3, 4) are made of silicon doped by the thermal diffusion of impurities such as arsenic and boron.

4. Device according to any one of Claims 1 to 3, characterized in that the substrate (1) comprises, in its central part (2), an electrically and thermally insulating material such as a silicon oxide.

5. Device according to any one of Claims 1 to 3, characterized in that the substrate (1') comprises, in its central part, a recess (2') which extends from the upper face (1'a) of the substrate (1') to a depth greater than that of the semiconductor strips (3, 4) formed on the substrate (1'), the said strips (3, 4) thus being isolated from the bottom (2'a) of the recess (2') by a layer of air.

6. Device according to any one of Claims 1 to 5, characterized in that the junctions present in the central region of the upper part (1a, 1'a) of the substrate (1, 1') consist of surface metallizations partially covering the ends of the semiconductor strips (3, 4).

7. Device according to any one of Claims 1 to 6, characterized in that it comprises two semiconductor strips (3', 4') electrically isolated from the series circuit and forming a thermocouple.
